**Europäisches Patentamt**

**European Patent Office**

**Office européen des brevets**

(19)

(11) Veröffentlichungsnummer: **0 089 641**
B1

(12) **EUROPÄISCHE PATENTSCHRIFT**

(45) Veröffentlichungstag der Patentschrift:
**11.03.87**

(51) Int. Cl.⁴: **H 04 B 9/00,** H 04 B 14/02,
H 03 J 9/06, G 08 C 19/26

(21) Anmeldenummer: **83102705.7**

(22) Anmeldetag: **18.03.83**

(54) **Fernsteuerempfänger, insbesondere zur Steuerung von Elektrogeräten.**

(30) Priorität: **24.03.82 DE 3210710**

(43) Veröffentlichungstag der Anmeldung:
**28.09.83 Patentblatt 83/39**

(45) Bekanntmachung des Hinweises auf die Patenterteilung:
**11.03.87 Patentblatt 87/11**

(84) Benannte Vertragsstaaten:
**AT BE CH DE FR IT LI LU NL SE**

(56) Entgegenhaltungen:
DE - A - 2 800 472
FR - A - 2 180 926
GB - A - 2 080 653
US - A - 2 817 025
US - A - 2 837 642
US - A - 3 558 902
US - A - 3 594 588

THE ELECTRONIC ENGINEER, Band 28, Nr. 12,
Dezember 1969, Seite 76, Beitrag Nr. 970, Radnor, USA
S. SHOU: "Rep rate comparison made simple"
THE ELECTRONIC ENGINEER
ELECTRONICS, Band 48, Nr. 6, März 1975, Seiten
123-126, New York, USA Thomas T. YEN: "C-MOS
flip-flop can do more than logic tasks"
NUCLEAR INSTRUMENTS AND METHODS, Band 140,

(73) Patentinhaber: **Brunnquell GmbH Fabrik
elektrotechnischer Apparate, Ettinger Strasse 32,
D-8070 Ingolstadt (DE)**

(72) Erfinder: **Becker, Klaus, Dipl.-Ing., Bamberger Str. 32,
D-8602 Mühlhausen (DE)**

(74) Vertreter: **Tergau, Enno et al, Tergau & Pohl
Patentanwälte Hefnersplatz 3 Postfach 9347,
D-8500 Nürnberg 11 (DE)**

(56) Entgegenhaltungen: (Fortsetzung)
Nr. 3, Februar 1977, Seiten 581-582, Amsterdam, NL.
R.R. GINGERICH et al: "A single-channel counting rate
monitor"
ELECTRONIC DESIGN, Band 28, Nr. 2, Januar 1980,
Seite 144, Rochelle Park, USA J.C.P. HANISKO: "Rate
limit sensor ignores transients; works without large
capacitors"
ELEKTROTECHNIK, Band 60, Nr. 3, Februar 1978, Seiten
16-18, Würzburg, DE. M. HADLEY:
"CMOS-Schmitt-Trigger"
ELEKTRONIK, Nr. 3, Februar 1980, Seiten 69-72, 83,
München, DE. J. GROSSE et al: "Lichtdimmen und
Schalten elektrischer Geräte mit
Infrarot-Fernsteuerung"

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen Fernsteuerempfänger, insbesondere zur Steuerung von Elektrogeräten mit den im Oberbegriff des Anspruches 1 angegebenen Merkmalen.

Fernsteuerempfänger dieser Art sind aus FR-A-2 180 926, GB-A-20 80 653 oder aus der Fachveröffentlichung «The Electronic Engineer», Band 28, Nr. 12, Dez. 1969, Seite 76, Beitrag Nr. 970 bekannt und werden in vielerlei Ausführungsformen benutzt. Sie werden beispielsweise für Spielzeugmodelle, Rundfunk- und Fernsehgeräte oder Elektrogeräte allgemein verwendet, wobei hierzu insbesondere auch elektrische Beleuchtungen zählen. Als Übertragungsmedium benutzt man elektromagnetische Wellen, infrarotes Licht oder auch Ultraschallwellen. Die Übertragung zum Fernsteuerempfänger erfolgt entweder durch den freien Raum bzw. durch die Luft, es können aber auch elektrische Leitungen oder optische Fasern verwendet werden. Neben einer Amplituden-, Frequenz- oder auch Implusbreitenmodulation des Übertragungssignals wird für die Informationsübertragung auch eine Implusfrequenzmodulation benutzt. Es soll darunter ein Übertragungssignal verstanden werden, das aus kurzen Implusen konstanter Amplitude besteht, deren Wiederholungsfrequenz die zu übertragende Information beinhaltet. Die Impulse können einem Träger aufmoduliert sein oder auch direkt beispielsweise als Infrarotlicht-Impulse ausgesendet werden.

In vielen Fällen ist ein möglichst geringer Leistungsverbrauch bei Fernsteuerempfängern erwünscht. Das gilt nicht nur für batteriebetriebene Geräte, sondern beispielsweise auch dann, wenn die Stromversorgung des Empfängers aus einer Dimmerschaltung zur Leistungsregelung netzbetriebener Verbraucher, insbesondere von Beleuchtungskörpern erfolgen soll. Solche Dimmerschaltungen regeln die Leistungszufuhr zum Verbraucher durch einen Phasenanschnitt der Wechselspannungshalbwellen mittels gesteuerter Halbleitergleichrichter (Thyristoren, Triacs). Bei maximaler Einschaltdauer des Halbleiterschalters je Halbperiode ergibt sich dann nur ein sehr kleiner Effektivwert für den Spannungsabfall und demgemäss nur eine sehr kleine Leistung für anzuschliessende Steuerschaltungen, beispielsweise einen Fernsteuerempfänger zur Ein- und Ausschaltung des angeschlossenen Verbrauchers bzw. auch zur Leistungs-, insbesondere Helligkeitsregelung von Beleuchtungskörpern.

Neben möglichst geringem Stromverbrauch sollen Fernsteuerempfänger das jeweils zugeordnete Übertragungssignal sicher erkennen, also nicht auf andere Signale, beispielsweise benachbarte Modulationsfrequenzen, Harmonische der Modulationsfrequenz oder auch impulsförmige Störsignale ansprechen. Eine weitere Anforderung geht dahin, dass nicht nur der Aufwand möglichst gering zu halten ist, sondern ausserdem wegen der beengten Platzverhältnisse in den zu steuernden Geräten, beispielsweise in Installationsschaltern mit eingebautem Dimmer der Platzbedarf bei kompaktem und sicherem Aufbau minimal zu halten ist.

Die FR-A-2 180 926 bzw. GB-A-20 80 653 beschreiben optische Kommunikationssysteme, die auf der Informationsübertragung durch Infrarotlicht-Impulse beruhen. Diese Einrichtungen dienen zur Steuerung von Elektrogeräten und sind mit einem Sensor für ein pulsfrequenzmoduliertes Übertragungssignal, einer Selektionsstufe für die Modulationsfrequenz und einer Ausgangsstufe zur Anschaltung des zu steuernden Gerätes ausgerüstet. Die Selektionsstufe weist dabei einen von den Modulationsimpulsen getriggerten, monostabilen Multivibrator (Monoflop) auf, dessen Verzögerungszeit kürzer als die Periodendauer der Modulationsfrequenz ist. Weiterhin ist dem Ausgang des monostabilen Multivibrators ein Integrator nachgeschaltet, der eine von der Modulationsfrequenz abhängige Gleichspannung erfolgt. Wenigstens ein dem Integrator nachgeschalteter Fensterdiskriminator liefert dann ein Signal an die Ausgangsstufe, wenn die vom Integrator bei einer vorgegebenen Modulationsfrequenz erzeugte Gleichspannung innerhalb eines das Fenster bildenden Bereiches liegt. Diese Bauweise ist insbesondere in der Fachveröffentlichung «The Electronic Engineer ....» offenbart. Als Diskriminator kommt dabei ein handelsüblicher integrierter Schaltkreis in Chipform zur Verwendung.

Der Erfindung liegt die Aufgabe zugrunde, einen Fernsteuerempfänger zu schaffen, der diese bekannten Bauformen von Fernsteuerempfängern verbessert, insbesondere bei kleinem Aufwand und kleinem Platzbedarf eine sichere Selektion des zugeordneten Übertragungssignals ermöglicht und mit sehr niedriger Betriebsleistung auskommt.

Zur Lösung der Aufgabe geht die Erfindung aus von einem Fernsteuerempfänger der eingangs genannten Art und ist dadurch gekennzeichnet, dass bei dem Fensterdiskriminator zwischen dem Integratorausgang und dem positiven Anschluss der Betriebsspannung $U_B$ des Empfängers bzw. dem Masseanschluss je ein aus zwei Widerständen bestehender Spannungsteiler geschaltet ist. Der Mittenabgriff des betriebsspannungsseitigen Spannungsteilers ist mit dem Eingang eines C-MOS-Inverters verbunden. Der Mittenabgriff des masseseitigen Spannungsteilers ist mit einem Eingang eines C-MOS-Gatters verbunden, dessen zweiter Eingang an den Ausgang des C-MOS-Inverters angeschlossen ist und dessen Ausgang das Signal S liefert. Wird der Fensterdiskriminator auf diese erfindungsgemässe Weise aus C-MOS-Logikbausteinen aufgebaut, von denen gemäss Anspruch 2 zwei Eingänge mit einer positiven bzw. negativen Spannungsverschiebung gleich der halben Fensterbreite an der Integratorausgangsspannung liegen, so haben beispielsweise Schwankungen der Betriebsspannung praktisch keinen Einfluss auf die Arbeitsweise. Es wird eine bekannte Eigenschaft der C-MOS-Logikbausteine ausgenutzt, die darin besteht, dass die Ausgangsspannung der Bausteine dann von L auf H bzw. umgekehrt springt, wenn die Eingangsspannung den Wert der halben Betriebsspannung durchläuft. Derartige Bausteine weisen darüber hinaus den Vorteil extrem niedriger Stromaufnahme in nahezu allen Betriebszuständen auf. Dadurch wird auch die Stromversorgung entsprechend vereinfacht. Zudem handelt es sich bei C-MOS-Logikbausteinen um preisgünstige Massenartikel, zusammen mit der vereinfachten Stromversorgung ergibt sich ein erheblicher Kostenvorteil gegenüber herkömmlichen Geräten dieser Art.

Gemäss den Unteransprüchen 3–5 kommen als Logikbausteine OR-, NOR-, AND-, NAND- oder Exklusiv-OR- und NOR-Verknüpfungsglieder in Frage.

Wenn die vom Integrator gelieferte Gleichspannung auf einen ausserhalb des Fensters liegenden Wert läuft, kann es beim kurzzeitigen Durchqueren des Fensters zu einer kurzzeitigen Fehlfunktion kommen. Eine Weiterbildung gemäss dem Kennzeichen des Anspruches 6 sieht daher vor, dass dem Verknüpfungsglied ein Integrator nachgeschaltet ist. Erst wenn also der Spannungswert längere Zeit innerhalb des Fensterbereiches ist, findet eine Beeinflussung der Ausgangsstufe statt.

Die Erfindung lässt sich in Verbindung mit einem Übertragungssignal im Bereich der Funkwellen oder auch in Verbindung mit Ultraschallsignalen einsetzen. In vielen Anwendungsfällen und insbesondere bei der Steuerung von elektrischen Geräten im Wohn- oder Bürobereich ist jedoch insbesondere auch im Hinblick auf die Reichweitenbegrenzung das Übertragungssignal zweckmässig, wie in Anspruch 7 angegeben ein getastetes Infrarotsignal zu verwenden, dessen Tastfrequenz die Modulationsfrequenz ist. Dieses Verfahren erlaubt den besonders wirtschaftlichen Einsatz eines batteriegespeisten Handsenders, welcher nur kurze und kräftige Infrarot-Blitze mit einer bestimmten Frequenz auszusenden hat. Der Sensor besteht dann aus einer infrarot-empfindlichen Diode und es ist ein Verstärker zwischen die Diode und den monostabilen Multivibrator geschaltet.

Bei einem solchen Fernsteuerempfänger kann in Weiterbildung der Erfindung gemäss Anspruch 8 die Ausgangsstufe eine elektronische Dimmerschaltung mit einem steuerbaren Halbleiterschalter sein, wobei die Betriebsspannung des Empfängers aus der Dimmerschaltung abgeleitet ist. Der sonst üblicherweise von Hand eingestellte Dimmer zur Helligkeitsregelung von Lampen und Leistungsregelung anderer Geräte kann dann auf einfache Weise ferngesteuert werden. Zweckmässig bilden dann die Bauteile des Fernsteuerempfängers ein kompaktes Steckmodul, das in einen mit einem Dimmer kombinierten Elektroinstallationsschalter einsteckbar ist. Diese Massnahme lehrt das Kennzeichen des Anspruches 9. Das Steckmodul lässt sich dabei auf ähnliche Weise und in ähnlicher Grösse ausbilden, wie die in bekannter Weise in einem Kunststoffsockel angeordneten Schmelzsicherungen, die die Dimmerschaltung vor zu hohen Einschaltströmen schützt. In der vorteilhaften Weiterbildung des Erfindungsgegenstandes gemäss Anspruch 10 können die Bauteile des Fernsteuerempfängers aber auch in die Betätigungsplatte eines mit einem Dimmer kombinierten Elektroinstallationsschalter eingebaut sein, wobei die infrarot-empfindliche Diode in einer Öffnung der Betätigungsplatte sitzt und gegebenenfalls mit einem Fenster abgedeckt ist.

Gemäss Anspruch 11 besteht in Weiterbildung der Erfindung auch die Möglichkeit, den Fernsteuerempfänger zusammen mit einer Dimmerschaltung oder einer Schaltstufe in einem Zwischenstecker unterzubringen. Ein solcher Zwischenstecker kann dann vom Endverbraucher an der jeweils gewünschten Stelle eingesetzt werden. Er braucht dazu nur in eine Steckdose gesteckt zu werden und nimmt mit einer Steckbuchse den Anschlussstecker des zu steuernden Gerätes auf. Eine andere Möglichkeit besteht darin, den Fernsteuerempfänger mit oder auch ohne die Dimmer- oder Schaltstufe vom Zwischenstecker mittels einer Leitung abzusetzen, wobei der Fernsteuerempfänger dann auch in einer versteckten Stelle sitzen kann. Weitere Möglichkeiten sind eine Kombination des Fernsteuerempfängers und Dimmers bzw. Schalters mit einer Tischsteckdose oder einem Schnurschalter bzw. -dimmer.

Nachfolgend wird ein Ausführungsbeispiel eines Fernsteuerempfängers nach der Erfindung anhand der Zeichnung beschrieben. Es zeigen:

Fig. 1 die Schaltung eines Fernsteuerempfängers nach der Erfindung;

Fig. 2 die bekannte Abhängigkeit der Ausgangsspannung von der Eingangsspannung bei C-MOS-Logikbausteinen;

Fig. 3 die Ausgangsspannung des Fensterdiskriminators in Abhängigkeit von seiner Eingangsspannung.

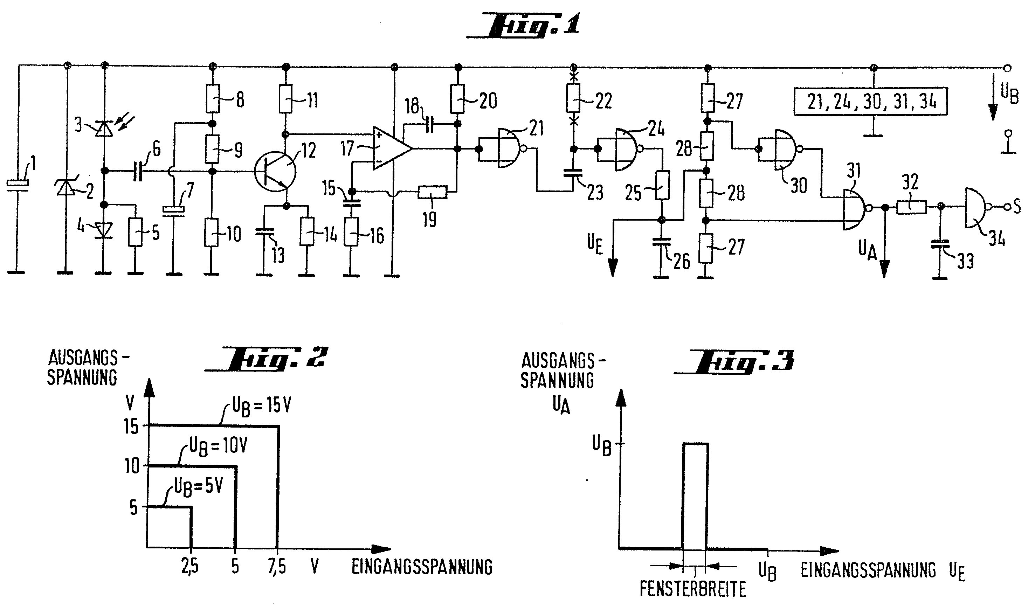

Die Betriebsspannung $U_B$ des Fernsteuerempfängers nach Fig. 1, die beispielsweise aus einem nachgeschalteten Dimmer abgeleitet ist, wird mit Hilfe einer Zenerdiode 2 auf einen Wert von beispielsweise 4,7 V begrenzt und durch einen Kondensator 1 geglättet. Eine infrarotempfindliche Diode 3 liegt über eine Diode 4 mit parallel geschaltetem Widerstand 5 in Sperrichtung an der Betriebsspannung $U_B$. Bei eintreffenden Infrarotimpulsen fliessen entsprechende Stromimpulse über die Diode 3, die zu einem Spannungsabfall an der Parallelschaltung aus den Bauteilen 4 und 5 führen. Über einen Koppelkondensator 6 gelangen die Spannungsimpulse an die Basis eines Transistors 12 mit einem Basisspannungsteiler, der aus den Widerständen 8, 9 und 10 sowie einem zusätzlichen Glättungskondensator 7 besteht. Ein Kollektorwiderstand 11 sowie ein Emitterwiderstand 14 mit parallelem Kondensator 13 stellen eine übliche Beschaltung des Transistors 12 dar, der das impulsförmige Empfangssignal dann zur weiteren Verstärkung dem nichtinvertierenden Eingang eines Operationsverstärkers 17 zuführt. Dieser besitzt in üblicher Weise eine Gegenkopplung vom Ausgang zum invertierenden Eingang mittels der Widerstände 16 und 19, wobei ein in Reihe mit dem Widerstand 16 liegender Kondensator 15 für eine Abschwächung niedriger Frequenzen sorgt. Ein zusätzlicher Kondensator 18 bewirkt eine Frequenzkompensation des Operationsverstärkers 17, dessen Ausgang über einen Widerstand 20 an der Betriebsspannung $U_B$ liegt.

Ein als Inverter geschaltetes NOR-Glied 21, das Teil eines gepufferten C-MOS-Bauteils CD 4001 B mit vier solchen NOR-Gliedern ist, dient als Impulsformer, an dessen Ausgang ein monostabiler Multivibrator (Monoflop) mit einem Kondensator 23, einem Widerstand 22 und einem wiederum als Inverter geschalteten NOR-Glied 24 angeschaltet ist. Mittels des Kondensators 23 und des Widerstandes 22 wird die Verzögerungszeit des Monoflops, also die Zeit, für die sich das Monoflop im instabilen Zustand befindet, auf einen Wert eingestellt, der etwa der halben Periodendauer der Modulationsfrequenz entspricht. Bei jedem eintreffenden Lichtimpuls erzeugt demgemäss das Monoflop am Ausgang des NOR-Gliedes 24 einen Impuls definierter Dauer. Ein nachgeschalteter Integrator mit einem Widerstand 25 und einem Integrationskondensator 26 setzt dann die Impulsfolgefrequenz, die gleich der Modulationsfrequenz ist, in eine zugeordnete Gleichspannung $U_E$ am Kondensator 26 um. Die Werte der Bauteile 22, 23 des Monoflops und der Bauteile 25, 26 des Integrators sind dabei so gewählt, dass sich bei der zu selektierenden Modulationsfrequenz eine Spannung $U_E$ am Kondensator 26 ergibt, die etwa gleich der halben Betriebsspannung $U_B$ ist.

Figur 2 zeigt eine bekannte Transferkennlinie gepufferter C-MOS-Bausteine. Man erkennt, dass die Ausgangsspannung bis etwa zur halben Betriebsspannung auf dem Wert der Betriebsspannung bleibt und dann plötzlich auf etwa 0 abfällt. Dieser Abfall tritt demgemäss bei den drei als Parameter dargestellten Betriebsspannungen von 5 V, 10 V und 15 V bei 2,5 V, 5 V bzw. 7,5 V auf. Diese Eigenschaften der C-MOS-Bausteine wird bei dem nachfolgend beschriebenen Fensterdiskriminator ausgenutzt.

Der Fensterdiskriminator besteht aus zwei NOR-Gliedern 30, 31 und zwei Spannungsteilern, die je einen Widerstand 27 und einen Widerstand 28 aufweisen. Die Spannungsteiler werden von der Spannung $U_E$ des Kondensators 26 gespeist und liegen auf der anderen Seite am gemeinsamen Bezugspotential (Masse) bzw. an der Betriebsspannung $U_B$. Die Werte der Widerstände 27, 28 sind so gewählt, dass die Spannung an den Anzapfpunkten zwischen den beiden Widerständen 27, 28 um einen kleinen Betrag entsprechend der halben Fensterbreite gegen die Spannung $U_E$ verschoben ist. Das Verhalten des Fensterdiskriminators soll unter zusätzlicher Bezugnahme auf Fig. 3 beschrieben werden, die die Ausgangsspannung $U_A$ am Ausgang des NOR-Gliedes 31 in Abhängigkeit von der Eingangsspannung $U_E$ am Kondensator 26 zeigt.

Bei niedrigen Werten der Eingangsspannung $U_E$ ist die Eingangsspannung des NOR-Gliedes 30 klein und jedenfalls kleiner als die halbe Betriebsspannung $U_B$, so dass der Ausgang des NOR-Gliedes 30 gemäss Fig. 2 etwa den Wert von $U_B$ hat (logisch H). Damit ist auch der erste Eingang des NOR-Gliedes 31 logisch H. Am zweiten Eingang des NOR-Gliedes 31 liegt ebenfalls eine Spannung, die kleiner als die halbe Betriebsspannung $U_B$ ist, so dass die Ausgangsspannung $U_A$ etwa 0 (logisch L) ist. Bei steigender Eingangsspannung $U_E$ erreicht zuerst die Spannung am Eingang des NOR-Gliedes 30 den Wert der halben Betriebsspannung $U_B$, und zwar dann, wenn die Spannung $U_E$ um den Betrag des Spannungsabfalls am Widerstand 28 oben kleiner als $U_{B/2}$ ist. Die Spannung am Ausgang des NOR-Gliedes 30 springt dann gemäss Fig. 2 auf etwa 0 V, und da die Spannung am zweiten Eingang des NOR-Gliedes 31 noch etwa um den doppelten Betrag des Spannungsabfalls am Widerstand 28 kleiner als $U_{B/2}$ ist, geht die Ausgangsspannung $U_A$ auf etwa den Wert der Betriebsspannung $U_B$, wie in Fig. 3 gezeigt. Dieser Zustand hält bei steigender Eingangsspannung $U_E$ an, bis auch die Spannung am zweiten Eingang des NOR-Gliedes 31 den Wert von $U_{B/2}$ erreicht. Da am ersten Eingang weiterhin eine Spannung von etwa 0 V ansteht, springt die Ausgangsspannung $U_A$ zurück auf etwa 0 V. Der Bereich der Eingangsspannung $U_E$, für den die Ausgangsspannung $U_A$ den Wert der Betriebsspannung $U_B$ hat, wird, wie in Fig. 3 angegeben, als Fensterbreite bezeichnet. Nur wenn die Modulationsfrequenz in einem engen Sollwertbereich liegt, stellt sich durch entsprechende Wahl der Bauteile eine Eingangsspannung $U_E$ ein, die innerhalb der Fensterbreite liegt. Nur dann wird also auch ein Ausgangssignal geliefert, im vorliegenden Fall ein Signal am Ausgang des NOR-Gliedes 31, das den Wert der Betriebsspannung $U_B$ hat.

Da bei einer Modulationsfrequenz grösser als die Sollfrequenz die Spannung $U_E$ am Kondensator 26 kurzzeitig das Fenster durchläuft, entsteht am Ausgang des NOR-Gliedes 31 ein kurzer Impuls mit der Betriebsspannung $U_B$, der zu Fehlfunktionen bei der nachfolgenden Schaltung führen könnte. Daher ist dem NOR-Glied 31 ein weiterer Integrator mit einem Widerstand 32 und einem Kondensator 33 nachgeschaltet, der eine Tiefpassfunktion hat. Nur wenn die Ausgangsspannung $U_A$ für längere Zeit auf dem Wert der Betriebsspannung $U_B$ ist, liefert ein Ausgangsinverter 34 ein Steuersignal S an die nachfolgende Schaltung, beispielsweise einen Dimmer. Eine Anpassung der Verzögerungszeit des Monoflops an die jeweilige Modulationsfrequenz kann, wie kleine Kreuze andeuten, durch Austauschen des Widerstandes 22 erfolgen.

**Patentansprüche**

1. Fernsteuerempfänger, insbesondere zur Steuerung von Elektrogeräten, mit einem Sensor (3) für ein pulsfrequenzmoduliertes Übertragungssignal, einer Selektionsstufe für Modulationsfrequenz oder -frequenzen und einer Ausgangsstufe zur Anschaltung des zu steuernden Gerätes, wobei die Selektionsstufe folgende Bauteile aufweist:

a) Einen von den Modulationsimpulsen getriggerten monostabilen Multivibrator (21, 22, 23, 24), dessen Verzögerungszeit kürzer als die Periodendauer der Modulationsfrequenz ist;

b) einen an den Ausgang des monostabilen Multivibrators angeschalteten Integrator (25, 26), der eine von der Modulationsfrequenz abhängige Gleichspannung erzeugt;

c) wenigstens einen an den Integrator angeschalteten Fensterdiskriminator (27, 28, 30, 31), der ein Signal (S) dann an die Ausgangsstufe liefert, wenn die vom Integrator bei einer vorgegebenen Modulationsfrequenz erzeugte Gleichspannung ($U_E$) innerhalb eines das Fenster bildenden Bereiches liegt, gekennzeichnet durch folgende Merkmale:

d) Bei dem Fensterdiskriminator (27, 28, 30, 31) ist zwischen dem Integratorausgang und dem positiven Anschluss der Betriebsspannung $U_B$ des Empfängers bzw. dem Masse-Anschluss je ein aus zwei Widerständen (27, 28) bestehender Spannungsteiler geschaltet,

e) der Mittenabgriff des betriebsspannungsseitigen Spannungsteilers ist mit dem Eingang eines C-MOS-Inverters (C-MOS-Logikbaustein 30) verbunden und

f) der Mittenabgriff des masseseitigen Spannungsteilers ist mit einem Eingang eines C-MOS-Gatters (C-MOS-Logikbaustein 31) verbunden,

- dessen zweiter Eingang an den Ausgang des C-MOS-Inverters (C-MOS-Logikbaustein 30) angeschlossen ist und

- dessen Ausgang das Signal S liefert.

2. Fernsteuerempfänger nach Anspruch 1, dadurch gekennzeichnet, dass die Widerstände (27, 28) der Spannungsteiler so bemessen sind, dass an den beiden, dem Integratorausgang benachbarten Widerständen (28) je eine Spannung gleich der halben Fensterbreite abfällt.

3. Fernsteuerempfänger nach Anspruch 2, dadurch gekennzeichnet, dass ein OR- oder NOR-Verknüpfungsglied (31) mit einem Eingang am Abgriff des zum negativen und mit einem weiteren Eingang über einen Inverter (30) am Abgriff des zum positiven Betriebsspannungsanschluss führenden Spannungsteilers liegt.

4. Fernsteuerempfänger nach Anspruch 2, dadurch gekennzeichnet, dass ein AND- oder NAND-Verknüpfungsglied mit einem Eingang am Abgriff des zum positiven und mit einem weiteren Eingang über einen Inverter am Abgriff des zum negativen Betriebsspannungsanschluss führenden Spannungsteilers liegt.

5. Fernsteuerempfänger nach Anspruch 2, dadurch gekennzeichnet, dass ein Exklusiv-OR- oder Exklusiv-NOR-Verknüpfungsglied mit zwei Eingängen an die Abgriffe der Spannungsteiler angeschaltet ist.

6. Fernsteuerempfänger nach Anspruch 3, 4 oder 5, dadurch gekennzeichnet, dass dem Verknüpfungsglied (31) ein Integrator (32, 33, 34) nachgeschaltet ist.

7. Fernsteuerempfänger nach einem der Ansprüche 1 bis 6, dadurch gekennzeichnet, dass das Übertragungssignal ein getastetes Infrarotsignal ist, dessen Tastfrequenz die Modulationsfrequenz ist, dass der Sensor eine infrarotempfindliche Diode (3) ist und dass ein Verstärker (12, 17) zwischen die Diode (3) und den monostabilen Multivibrator (21, 22, 23, 24) geschaltet ist.

8. Fernsteuerempfänger nach einem der Ansprüche 1 bis 7, dadurch gekennzeichnet, dass die Ausgangsstufe eine elektronische Schaltung mit einem steuerbaren Schalter oder Dimmer ansteuert, und dass die Betriebsspannung ($U_B$) des Empfängers aus der Schaltung abgeleitet ist.

9. Fernsteuerempfänger nach Anspruch 8, dadurch gekennzeichnet, dass die Bauteile des Fernsteuerempfägers ein kompaktes Steckmodul bilden und dass das Steckmodul in einen Elektroinstallationsschalter oder -dimmer einsteckbar ist.

10. Fernsteuerempfänger nach Anspruch 8, dadurch gekennzeichnet, dass die Bauteile des Fernsteuerempfängers in die Betätigungsplatte eines Elektroinstallationsschalters oder -dimmers eingebaut sind.

11. Fernsteuerempfänger nach Anspruch 8, gekennzeichnet durch seinen Einbau in ein Zwischengerät, beispielsweise einen Zwischenstecker.

**Claims**

1. Remote-control receiver, in particular for the control of electrical appliances, with a sensor (3) for a pulse frequency modulated transmission signal, a selection stage for modulation frequency or frequencies and an output stage for the connection of the appliance to be controlled, the selection stage having the following components:

a) A monostable multivibrator (21, 22, 23, 24) which is triggered by the modulation pulses and whose delay time is shorter than the cycle duration of the modulation frequency;

b) An integrator (25, 26) which is connected to the output of the monostable multivibrator and generates a direct-current voltage dependent on the modulation frequency;

c) At least one window discriminator (27, 28, 30, 31) which is connected to the integrator and supplies a signal (S) to the output stage whenever the direct-current voltage ($U_E$) generated by the integrator at a given modulation frequency lies within a region forming the window, characterized by the following features:

d) In the case of the window discrminator (27, 28, 30, 31) a voltage divider, consisting of two resistors (27, 28) in each case, is connected between the integrator output and the positive terminal of the operating voltage $U_B$ of the receiver and between the integrator output and the earth terminal,

e) The centre tap of the voltage divider on the operating voltage side is connected to the input of a C-MOS inverter (C-MOS logic module 30), and

f) The centre tap of the voltage divider on the earth side is connected to an input of a C-MOS gate (C-MOS logic module 31),

- whose second input is connected to the output of the C-MOS inverter (C-MOS logic module 30) and

- whose output supplies the signal S.

2. Remote-control receiver according to Claim 1, characterized in that the resistors (27, 28) of the voltage dividers are dimensioned such that a voltage equal to half the window width drops at each of the two resistors (28) neighbouring the integrator output.

3. Remote-control receiver according to Claim 2, characterized in that an OR or NOR logic element (31) lies with one input at the tap of the voltage divider leading to the negative operating voltage terminal and with another input lies via an inverter (30) at the tap of the voltage divider leading to the positive operating voltage terminal.

4. Remote-control receiver according to Claim 2, characterized in that an AND or NAND logic element lies with one input at the tap of the voltage divider leading to the positive operating voltage terminal and lies with another input via an inverter at the tap of the voltage divider leading to the negative operating voltage terminal.

5. Remote-control receiver according to Claim 2, characterized in that an exclusive-OR or exclusive-NOR logic element is connected by two inputs to the taps of the voltage dividers.

6. Remote-control receiver according to Claim 3, 4 or 5, characterized in that an integrator (32, 33, 34) is connected downstream of the logic element (31).

7. Remote-control receiver according to one of Claims 1 to 6, characterized in that the transmission signal is a keyed infrared signal, whose keying frequency is the modulation frequency, in that the sensor is an infrared-sensitive diode (3) and in that an amplifier (12, 17) is connected between the diode (3) and the monostable multivibrator (21, 22, 23, 24).

8. Remote-control receiver according to one of Claims 1 to 7, characterized in that the output stage triggers an electronic circuit with a controllable switch or dimmer and in that the operating voltage ($U_B$) of the receiver is derived from the circuit.

9. Remote-control receiver according to Claim 8, characterized in that the components of the remote-control receiver form a compact plug-in module and in that the plug-in module can be plugged into an electronic installation switch or dimmer.

10. Remote-control receiver according to Claim 8, characterized in that the components of the remote-control receiver are fitted in the control plate of an electrical installation switch or dimmer.

11. Remote-control receiver according to Claim 8, characterized by its fitting in an intermediate device, for example an adaptor plug.

**Revendications**

1. Récepteur de télécommande, en particulier pour la commande d'appareils électriques, comprenant un capteur (3) pour un signal de transmission à modulation d'impulsions en fréquence, un étage de sélection pour une ou plusieurs fréquences de modulation et un étage de sortie pour le branchement de l'appareil à commander, l'étage de sélection présentant les éléments suivants:

a) un multivibrateur monostable (21, 22, 23, 24) déclenché par les impulsions de modulation et dont le temps de retard est plus court que la durée de période de la fréquence de modulation;

b) un intégrateur (25, 26) connecté à la sortie du multivibrateur monostable et qui produit une tension continue fonction de la fréquence de modulation; et

c) au moins un discriminateur à fenêtre (27, 28, 30, 31) connecté à l'intégrateur et qui délivre un signal (S) à l'étage de sortie lorsque la tension continue ($U_E$), produite par l'intégrateur à une fréquence de modulation préfixée, tombe dans une plage formant la fenêtre, caractérisé en ce que:

c) le discriminateur à fenêtre (27, 28, 30, 31) comporte deux diviseurs de tension constitués chacun de deux résistances (27, 28), un entre la sortie de l'intégrateur et la borne positive de la tension de service ($U_B$) du récepteur et un autre entre la sortie de l'intégrateur et la borne de masse,

e) la prise médiane du diviseur de tension côté tension de service est connectée à l'entrée d'un inverseur CMOS (composant logique CMOS 30) et

f) la prise médiane du diviseur de tension côté masse est connectée à une entrée d'une porte CMOS (composant logique CMOS 31)

- dont la deuxième entrée est connectée à la sortie de l'inverseur CMOS (composant logique CMOS 30) et

- dont la sortie délivre le signal (S).

2. Récepteur selon la revendication 1, caractérisé en ce que les résistances (27, 28) des diviseurs de tension sont dimensionnées de manière que la chute de tension sur chacune des résistances (28) voisines de la sortie de l'intégrateur soit égale à la demi largeur de fenêtre.

3. Récepteur selon la revendication 2, caractérisé en ce qu'un élément logique OU ou NOR (31) est relié par une entrée à la prise du diviseur de tension menant à la borne négative de la tension de service et est relié par une autre entrée et à travers un inverseur (30) à la prise du diviseur de tension menant à la borne positive de la tension de service.

4. Récepteur selon la revendication 2, caractérisé en ce qu'un élément logique ET ou NON-ET est relié par une entrée à la prise du diviseur de tension menant à la borne positive de la tension de service et est relié par une autre entrée et à travers un inverseur à la prise du diviseur de tension menant à la borne négative de la tension de service.

5. Récepteur selon la revendication 2, caractérisé en ce qu'un élément logique OU exclusif ou NOR exclusif est relié par deux entrées aux prises des diviseurs de tension.

6. Récepteur selon la revendication 3, 4 ou 5, caractérisé en ce qu'un intégrateur (32, 33, 34) est monté à la suite de l'élément logique (31).

7. Récepteur selon une des revendications 1 à 6, caractérisé en ce que le signal de transmission est un signal infrarouge à impulsions dont la fréquence d'impulsions est la fréquence de modulation, que le capteur est une diode (3) sensible à l'infrarouge et qu'un amplificateur (12, 17) est monté entre la diode (3) et le multivibrateur monostable (21, 22, 23, 24).

8. Récepteur selon une des revendications 1 à 7, caractérisé en ce que l'étage de sortie attaque un circuit électronique comportant un interrupteur ou un variateur de lumière pouvant être commandé et que la tension de service ($U_B$) du récepteur est tirée de ce circuit.

9. Récepteur selon la revendication 8, caractérisé en ce que les éléments du récepteur constituent un module à enficher compact et en ce que ce module peut être enfiché dans un interrupteur ou un variateur de lumière d'une installation électrique.

10. Récepteur selon la revendication 8, caractérisé en ce que les éléments du récepteur sont incorporés dans la plaque de commande d'un interrupteur ou d'un variateur de lumière d'une installation électrique.

11. Récepteur selon la revendication 8, caractérisé par son incorporation dans un appareil intermédiaire, par exemple dans une fiche intermédiaire de prise de courant.

*Fig. 1*

21, 24, 30, 31, 34

*Fig. 2*

AUSGANGS-
SPANNUNG

V

U_B = 15 V

15

U_B = 10 V

10

U_B = 5 V

5

2,5    5    7,5    V    EINGANGSSPANNUNG

*Fig. 3*

AUSGANGS-
SPANNUNG
U_A

U_B

U_B    EINGANGSSPANNUNG  U_E

FENSTERBREITE

0 089 641